(19) Europäisches Patentamt
European Patent Office
Office européen des brevets

(11) **EP 2 504 943 B1**

(12) **FASCICULE DE BREVET EUROPEEN**

(45) Date de publication et mention
de la délivrance du brevet:
**18.05.2016 Bulletin 2016/20**

(51) Int Cl.:
***H04L 1/00*** *(2006.01)* ***H03M 13/29*** *(2006.01)*

(21) Numéro de dépôt: **10793188.3**

(86) Numéro de dépôt international:
**PCT/EP2010/068338**

(22) Date de dépôt: **26.11.2010**

(87) Numéro de publication internationale:
**WO 2011/064345 (03.06.2011 Gazette 2011/22)**

(54) **PROCÉDÉ DE TURBOCODAGE DISTRIBUÉ ADAPTATIF POUR RÉSEAU COOPÉRATIF**

ADAPTIVES VERTEILTES TURBOCODIERVERFAHREN FÜR EIN KOOPERATIVES NETZWERK

ADAPTIVE DISTRIBUTED TURBO CODING METHOD FOR A COOPERATIVE NETWORK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.11.2009 FR 0958435**

(43) Date de publication de la demande:
**03.10.2012 Bulletin 2012/40**

(73) Titulaire: **Commissariat à l'Énergie Atomique et aux Énergies Alternatives 75015 Paris (FR)**

(72) Inventeur: **CALVANESE STRINATI, Emilio F-38000 Grenoble (FR)**

(74) Mandataire: **Ilgart, Jean-Christophe et al BREVALEX 95, rue d'Amsterdam 75378 Paris Cedex 8 (FR)**

(56) Documents cités:
**US-A1- 2004 266 358**

- **THOBABEN R: "On distributed codes with noisy relays", SIGNALS, SYSTEMS AND COMPUTERS, 2008 42ND ASILOMAR CONFERENCE ON, IEEE, PISCATAWAY, NJ, USA, 26 octobre 2008 (2008-10-26), pages 1010-1014, XP031475440, ISBN: 978-1-4244-2940-0**
- **YUANYUAN ZHANG ET AL: "Improved coded cooperation schemes for wireless communications", MODELING AND OPTIMIZATION IN MOBILE, AD HOC, AND WIRELESS NETWORKS AND WORKSHOPS, 2008. WIOPT 2008. 6TH INTERNATIONAL SYMPOSIUM ON, IEEE, PISCATAWAY, NJ, USA, 1 avril 2008 (2008-04-01), pages 533-538, XP031295939, ISBN: 978-963-9799-18-9**
- **HIEU T NGUYEN ET AL: "Bandwidth-efficient Bit-interleaved Coded Cooperative Communications", WIRELESS PERSONAL COMMUNICATIONS, KLUWER ACADEMIC PUBLISHERS, DO, vol. 46, no. 3, 16 novembre 2007 (2007-11-16), pages 247-268, XP019617235, ISSN: 1572-834X**

**Description**

**DOMAINE TECHNIQUE**

La présente invention concerne de manière générale le domaine des réseaux dits coopératifs et plus particulièrement ceux utilisant un turbocodage distribué entre un terminal source et au moins un terminal.

**ÉTAT DE LA TECHNIQUE ANTÉRIEURE**

Les réseaux de télécommunication sans fil souffrent traditionnellement de limitations dues aux phénomènes d'évanouissement et d'interférence affectant les canaux de transmission. Afin de remédier à ces limitations, des stratégies de coopération entre terminaux d'un réseau ont été proposées. On trouvera par exemple une description de telles stratégies de coopération dans l'article de S. Valentin et al. intitulé « Cooperative wireless networking beyond store-and forward: perspectives for PHY and MAC design » publié dans Wireless Personal Communications, édité chez Springer Link, 2009.

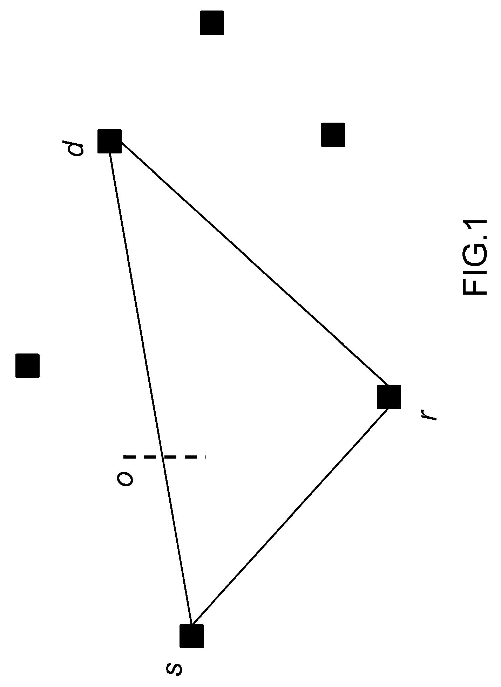

La Fig. 1 représente de manière très schématique une stratégie de coopération au sein d'un réseau sans fil. On suppose qu'un terminal source s transmet un flux de données à un terminal destinataire d. Le terminal r reçoit également le flux de données issu de s et le relaie au terminal destinataire *d*. Le terminal *r* coopère ainsi à la transmission de données entre les terminaux *s* et *d*. Par exemple, si le canal *s-d* est de mauvaise qualité, notamment à cause de la présence d'un obstacle o entre s et d (par exemple configuration NLOS), le canal *s-r-d* peut permettre de le contourner et d'obtenir une qualité de liaison satisfaisante. Le flux de données peut être relayé par plusieurs terminaux pour davantage augmenter la diversité spatiale des trajets de transmission.

On connaît les familles de partage d' accès dans un réseau sans fil : TDMA (partage temporel), CDMA (partage par code), SDMA (partage spatial). Dans un réseau TDMA (*Time Division Multiple Access*), chaque terminal possède un intervalle de transmission qui lui est dédié. On distingue deux modes de coopération possibles dans un réseau TDMA coopératif : la coopération parallèle et la coopération série.

Dans un mode de coopération parallèle, le terminal relais reçoit les données du terminal source pendant l'intervalle de transmission alloué à ce dernier et les retransmet vers le terminal destinataire durant son propre intervalle de transmission. Le terminal destinataire reçoit ainsi les mêmes données, via des trajets différents, une première fois pendant l'intervalle de transmission du terminal source et une seconde fois pendant l'intervalle de transmission du terminal relais. Bien que le qualificatif de parallèle puisse paraître mal choisi du fait de la réception séquentielle des données par le terminal destinataire, il fait en fait référence à l'absence d'interférence entre les deux trajets, résultant de la séparation temporelle des intervalles de transmission des terminaux source et relais. Le fonctionnement en mode de coopération parallèle suppose que le terminal relais n' ait pas de données propres à transmettre pendant son intervalle de transmission.

Dans un mode de coopération série, le terminal relais reçoit les données du terminal source pendant l'intervalle de transmission de ce dernier et les retransmet dans le même intervalle. Le terminal destinataire reçoit ainsi les données du terminal source, via deux trajets différents pendant un intervalle de transmission du terminal source.

Du fait de la transmission simultanée des données propres et des données relayées pendant le même intervalle de transmission, ces données sont généralement transmises sur des fréquences différentes ou à l'aide de codes orthogonaux.

De manière générale, nous nous intéresserons à un réseau coopératif comprenant un terminal source s, un terminal destinataire d et au moins un terminal relais r, indépendamment du type de la stratégie de coopération envisagée. Les canaux de transmission *s-d* et *r-d* peuvent notamment correspondre à des intervalles de transmission différents et/ou à des fréquences de transmission différentes.

Une stratégie de coopération particulièrement élégante a été proposée dans l'article de B. Zhao et al. intitulé « Distributed turbo coded diversity for relay channel » publié dans Electronics Letters, Vol. 29, No. 10, 15 Mai 2003. Cette stratégie vise à implémenter un turbocodeur distribué entre un terminal source et un terminal relais, une première composante du turbocode étant implémentée dans le terminal source et un seconde du turbocode dans le terminal relais.

Dans l'article de Ragnar Thobaben intitulé "On distributed codes with noisy relays", IEEE conference on signals, systems and computers, 26 Octobre 2008,pages 1010-1014, un système de turbo codage distribué est présenté et les performances de différents codeurs à la source et au relais sont simulées en fonction du rapport signal sur bruit ou de l'information mutuelle.

On rappelle tout d'abord que les turbocodes ont été introduits par C. Berrou et al. dans l'article fondateur « Near Shannon limit error-correcting coding and decoding : Turbo Codes », Proceedings of ICC'93 pp. 1064-1070, et qu'ils ont depuis lors fait l'objet de nombreuses recherches. Les turbocodes présentent en effet des performances remarquables en termes de taux d'erreur binaire ou BER (Bit *Error Rate*) ou de taux d'erreur paquet (*Frame Error Rate*), permettant d'approcher la capacité de Shannon du canal.

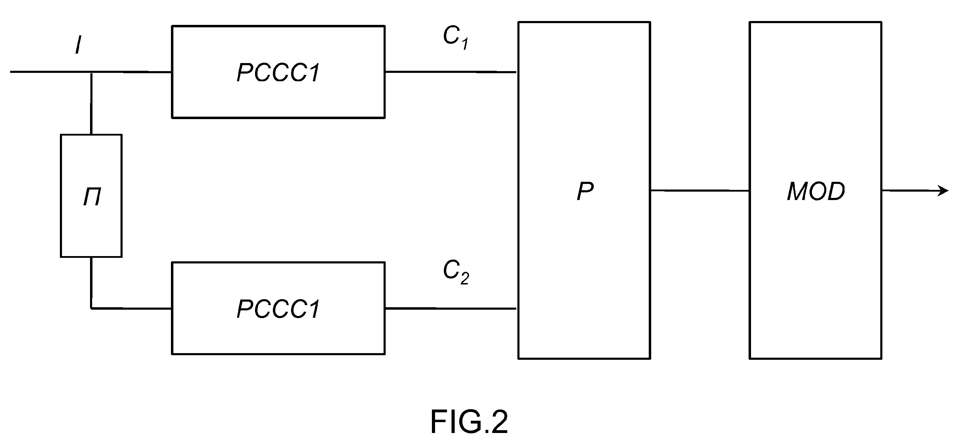

On a représenté en Fig. 2 un exemple de turbocodeur constitué par la concaténation parallèle de deux codeurs convolutifs *PCCC*1 et *PCCC*2. Les bits d'information à transmettre, symbolisés par le flux *I*, sont codés d'une part au moyen du codeur convolutif *PCCC*1 et d'autre part au moyen du codeur convolutif *PCCC*2, après avoir été entrelacés au moyen de l'entrelaceur Π. Les bits ainsi codés, symbolisés par le flux $C_1$ en sortie de $PCCC_1$ et le flux $C_2$ en sortie de $PCCC_2$ peuvent faire l'objet d'un poinçonnage dans le poinçonneur *P*. Les flux de bits ainsi poinçonnés, sont ensuite modulés par un modulateur bit à symbole *MOD* avant d'être transmis sur le canal.

Classiquement, les codeurs convolutifs *PCCC*1 et *PCCC*2 sont des codeurs récursifs systématiques. Dans ce cas, l'homme du métier comprendra que le codeur *PCCC*1 fournit les bits d'information *I* et des bits de parité $P_1$, le codeur *PCCC*1 ne fournissant alors que des bits de parité $P_2$ sans fournir à nouveau la partie systématique.

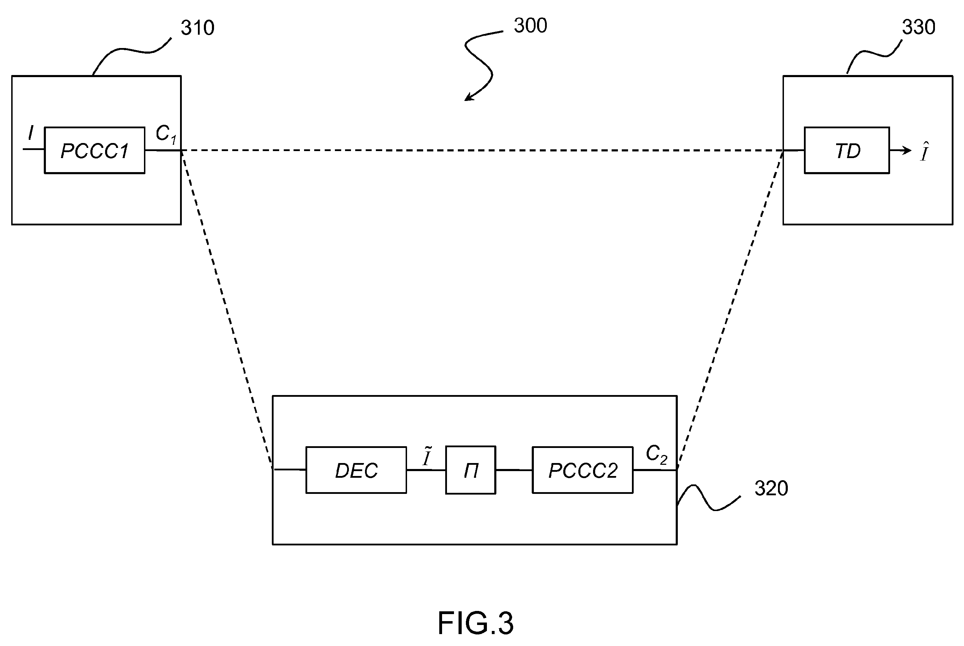

La Fig. 3 représente un exemple de réseau coopératif tel que décrit dans l'article de B. Zhao et *al*. précité.

Le réseau coopératif, 300, comprend un turbocodeur distribué entre un terminal source 310 et un terminal relais 320. Plus précisément, les bits d'information *I* sont codés au sein du terminal source 310 par un premier codeur convolutif $PCCC_1$. Le flux de bits ainsi codés, noté $C_1$, est éventuellement poinçonné avant de faire l'objet d'une modulation bit à symbole. Pour des raisons de simplification, le poinçonneur (optionnel) et le modulateur n'ont pas été représentés sur le schéma.

Les symboles ainsi transmis sont reçus par le terminal relais, 320, d'une part et le terminal destinataire, 330, d'autre part.

Les symboles reçus par le terminal relais 320 sont d'abord démodulés par un démodulateur symbole à bit (non représenté) et les bits ainsi obtenus sont décodés au moyen du décodeur *DEC*. Les bits décodés, constituant le flux $\tilde{I}$, sont entrelacés par l'entrelaceur Π avant de faire l'objet d'un nouveau codage dans le second codeur convolutif $PCCC_2$. Les codeurs *PCCC*1 *et* $PCCC_2$ sont des codeurs récursifs systématiques de même structure. Le flux de bits codés, noté $C_2$, fait l'objet d'un poinçonnage avant d'être modulé par un modulateur bit à symbole. Là encore, le poinçonneur et le modulateur n'ont pas été représentés pour des raisons de simplification.

Le terminal destinataire, 330, reçoit ainsi sur des ressources distinctes (intervalles de transmission, fréquences de transmission, codes orthogonaux) les symboles transmis par le terminal source et le terminal relais. La séparation spatiale entre le terminal source et le terminal relais, d'une part, et accessoirement l'utilisation de ressources de transmission distinctes, d'autre part, introduisent une diversité de transmission qui peut être exploitée par le récepteur. On note $\tilde{C}_1$ le flux de bits reçus du terminal source et $\tilde{C}_2$ le flux de bits reçus du terminal relais.

Le récepteur comprend un turbodécodeur *TD* de structure classique effectuant des itérations de décodage, chaque itération mettant en oeuvre un premier décodeur élémentaire correspondant au premier codeur convolutif et opérant sur le flux $\tilde{C}_1$ et un second décodeur élémentaire correspondant au second codeur convolutif et opérant sur le flux $\tilde{C}_2$, un décodeur élémentaire estimant et transmettant à l'autre des informations extrinsèques sur les bits systématiques à chaque demie itération.

Le réseau coopératif illustré en Fig. 3 possède des performances satisfaisantes lorsque les canaux de transmission respectifs entre le terminal source et le terminal destinataire, et entre le terminal relais et le terminal destinataire, sont des canaux gaussiens (AWGN) présentant des rapports signal sur bruit (SNR) de même ordre de grandeur. Toutefois, en pratique ces conditions sont rarement remplies car les canaux présentent des évanouissements qui varient en fonction du temps et de la fréquence. En outre, même dans le cas où les terminaux sont fixes et les canaux ne présentent pas d'évanouissement, le rapport signal sur bruit est rarement du même ordre de grandeur sur les deux trajets *s-d* et *r-d*.

Un objet de la présente invention est par conséquent de proposer une méthode de transmission dans un réseau coopératif qui remédie aux problèmes précédents, en particulier qui permette d'obtenir de bonnes performances en termes de taux d'erreur bit ou paquet, dans des situations réelles, notamment lorsque les canaux présentent des évanouissements.

**EXPOSÉ DE L'INVENTION**

La présente invention est définie par une méthode de transmission de paquets de données pour réseau coopératif comprenant un terminal source, un terminal destinataire et au moins un terminal relais selon la revendication 1. Généralement, le terminal source code un paquet de données à l'aide d'un premier codeur convolutif pour générer un premier paquet codé et le transmettre au terminal destinataire ainsi qu'au terminal relais. Le terminal relais reçoit et décode le premier paquet codé, entrelace les données du paquet ainsi décodé et code le paquet de données entrelacées à l'aide d'un second codeur convolutif pour générer un second paquet codé et le transmettre au dit terminal destinataire, le premier et le second codeurs convolutifs formant un turbocodeur distribué entre le terminal source et le terminal relais. Selon la méthode de l'invention :

(a) on sélectionne ledit premier codeur convolutif parmi une pluralité de premiers codeurs convolutifs prédéterminés, et/ou

(b) on sélectionne ledit second codeur convolutif parmi une pluralité de seconds codeurs convolutifs prédéterminés ;

la sélection en (a) et/ou (b) étant effectuée à partir d'une caractéristique du canal entre le terminal source et le terminal destinataire et/ou du canal entre le terminal relais et le terminal destinataire.

Selon une première variante, ladite caractéristique du canal comprend le type d'environnement dans lequel il est situé.

Par exemple, ladite caractéristique du canal comprend le caractère fixe ou mobile du terminal destinataire.

Selon une seconde variante, ladite caractéristique du canal comprend une information sur l'état du canal renvoyée par le terminal destinataire.

Ladite caractéristique du canal peut être par exemple un taux d'erreur bit ou un taux d'erreur paquet.

Ladite caractéristique du canal peut encore être un rapport signal sur bruit.

Dans ce cas, lorsque le rapport signal sur bruit sur le canal est inférieur à un premier seuil prédéterminé, on peut sélectionner un premier codeur convolutif de type faible et lorsque ce même rapport signal est supérieur à ce premier seuil, on peut sélectionner un premier codeur convolutif de type fort.

Lorsque le rapport signal sur bruit sur le canal est inférieur à un second seuil prédéterminé, on peut également sélectionner un second codeur convolutif de type faible et lorsque ce même rapport signal est supérieur à ce premier seuil, on peut sélectionner un second codeur convolutif de type fort.

Lorsque le rapport signal sur bruit sur le canal entre le terminal source et le terminal destinataire est supérieur à celui sur le canal entre le terminal relais et le terminal destinataire, on peut sélectionner, dans le terminal source, un premier codeur convolutif plus fort que le second codeur convolutif et, dans le cas contraire, on peut sélectionner un premier codeur convolutif plus faible que le second codeur convolutif.

Selon l'invention, ledit canal est un canal à évanouissements par bloc et ladite caractéristique peut avantageusement comprendre des statistiques des coefficients d'évanouissement sur le canal.

Dans ce cas, pour chaque premier codeur convolutif et/ou second codeur convolutif prédéterminé, on calcule avantageusement les probabilités conditionnelles d'erreur bit ou d'erreur paquet relatives aux différentes valeurs possibles desdits coefficients d'évanouissement et on en déduit des bornes de probabilité d'erreur bit ou d'erreur paquet que l'on obtiendrait en utilisant ledit premier codeur convolutif et/ou ledit second codeur convolutif prédéterminé.

Dans ce cas, on peut sélectionner le premier codeur convolutif et/ou le second convolutif prédéterminé permettant d'obtenir la plus faible borne de taux d'erreur bit ou de taux d'erreur paquet.

Selon un premier mode de réalisation, le terminal source contrôle à la fois la sélection du premier et/ou du second codeur convolutif.

Alternativement, selon un second mode de réalisation, le terminal source contrôle la sélection du premier codeur convolutif et/ou le terminal relais contrôle la sélection du second codeur convolutif.

## BRÈVE DESCRIPTION DES DESSINS

D'autres caractéristiques et avantages de l'invention apparaîtront à la lecture d'un mode de réalisation préférentiel de l'invention fait en référence aux figures jointes parmi lesquelles :

La Fig. 1 illustre de manière schématique un exemple très simple de réseau coopératif connu de l'état de la technique ;
La Fig. 2 illustre de manière schématique un exemple de turbocodeur connu de l'état de la technique ;
La Fig. 3 illustre de manière schématique un réseau coopératif utilisant un turbocodeur distribué entre un terminal source et un terminal relais, tel que connu de l'état de la technique ;
La Fig. 4 illustre de manière schématique un réseau coopératif selon un premier mode de réalisation de l'invention ;
La Fig. 5 illustre de manière schématique un réseau coopératif selon un second mode de réalisation de l'invention ;
La Fig. 6 illustre de manière schématique un réseau coopératif selon un troisième mode de réalisation de l'invention.

## EXPOSÉ DÉTAILLÉ DE MODES DE RÉALISATION PARTICULIERS

Nous considérerons à nouveau le cas d'un système de télécommunication coopératif comprenant un terminal source, un terminal destinataire et au moins un terminal relais. Nous supposerons que chaque terminal transmet les données par paquets (ou trames) grâce à des ressources de transmission qui lui sont dédiées, par exemple telles que des intervalles de temps de transmission (TTI), des fréquences ou des intervalles de sous porteuses (dans un multiplex OFDM), des codes de transmission ou encore une combinaison de telles ressources. Comme mentionné précédemment, le terminal source et le terminal relais utilisent des ressources distinctes. Par exemple, le terminal source pourra transmettre un paquet de données sur un premier intervalle de sous-porteuses (ou *chunk*) et le terminal pourra le relayer (après l'avoir décodé, entrelacé et recodé) sur un second intervalle de sous-porteuses distinct du premier. Toutefois l'invention ne saurait être limitée à l'utilisation d'un type particulier de ressources de transmission.

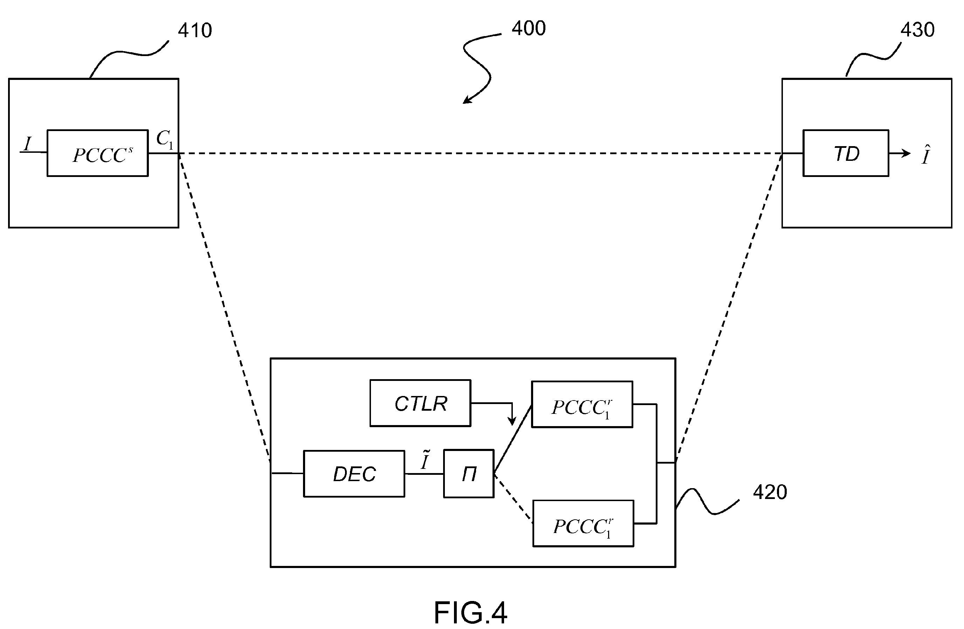

La Fig. 4 illustre de manière schématique un réseau coopératif selon un premier mode de réalisation de l'invention.

On a représenté en 410 un terminal source, en 420 un terminal relais et en 430 un terminal destinataire. De manière générale, le réseau coopératif peut mettre en oeuvre une pluralité de terminaux relais pour relayer les paquets de données du terminal source au terminal destinataire. Par souci de simplification mais sans perte de généralité, nous supposerons dans la suite qu'un seul terminal relais est utilisé.

Le terminal source comprend un premier codeur convolutif $PCCC^s$ pour coder les paquets de bits d'information $I$. Le cas échéant, les paquets ainsi codés subissent un poinçonnage avant d'être modulés par un modulateur bit à symbole. Pour des raisons de simplification, le poinçonneur (optionnel) ainsi que le modulateur bit à symbole ne sont pas représentés. Les symboles de modulation obtenus sont ensuite transmis par le terminal source sur une première ressource de transmission. Par exemple, ces symboles peuvent moduler les sous-porteuses d'un multiplex OFDM (plus précisément les sous-porteuses d'un *chunk*) ou être étalés spectralement à l'aide d'un code, de manière connue en soi.

Le terminal relais reçoit le signal transmis par le terminal source et le démodule pour obtenir les paquets de données codées. Les bits ainsi obtenus sont ensuite décodés par le décodeur *DEC* puis recodés par un second codeur convolutif, $PCCC_n^r$, sélectionné parmi une pluralité $N$ de codeurs convolutifs prédéterminés $PCCC_1^r$ , ... , $PCCC_N^r$ . Ces codeurs convolutifs correspondent avantageusement à des codes de distances minimales différentes. Ils peuvent en particulier être des codeurs récursifs systématiques avec des réponses impulsionelles de longueurs de cycles différentes. La sélection du second codeur convolutif parmi $N$ est contrôlée par le contrôleur *CTLR*. Le paquet de bits recodés par le second codeur convolutif fait ensuite l'objet d'une modulation bit à symbole avant d'être transmis sur une seconde ressource de transmission distincte de la première.

Le terminal destinataire, 430, reçoit un premier paquet codé par le premier codeur convolutif, $PCCC^s$, via le canal de transmission *s-d* et un second paquet codé par le second codeur convolutif sélectionné, $PCCC_n^r$, via le canal de transmission *r-d,* les premier et second paquets codés ayant été obtenus à partir du même paquet de bits d'information $I$. Le turbodécodeur *TD* effectue des itérations de décodage à l'aide d'un premier décodeur élémentaire correspondant au premier codeur convolutif et un second décodeur élémentaire correspondant au second codeur convolutif, de manière connue en soi.

De manière générale, la sélection du second codeur convolutif dépend d'une caractéristique du canal de transmission *s-r* et/ou du canal de transmission *r-d.*

Selon une première variante, cette caractéristique est le type du canal en question et plus précisément le type de l'environnement dans lequel il est situé. Par exemple, le terminal relais peut comprendre deux seconds codeurs convolutifs $PCCC_1^r$ et $PCCC_2^r$ , le premier dédié à un environnement urbain et le second à un environnement rural. Le type d'environnement peut être fourni localement par le réseau coopératif, par exemple, dans un réseau cellulaire, par la station de base de la cellule dans laquelle se trouvent les terminaux. Alternativement, les deux codeurs convolutifs peuvent être respectivement dédiés au cas où le terminal destinataire est fixe et au cas où il est mobile. Par exemple, le terminal destinataire peut mesurer le décalage Doppler d'une fréquence porteuse ou mesurer sa vitesse à l'aide d'un système de positionnement GPS et en avertir le terminal relais.

Selon une seconde variante, la caractéristique est une information sur l'état du canal *s-d* et/ou du canal *r-d.* Cette information sur l'état du canal peut être par exemple estimée par le terminal destinataire à l'aide de symboles pilotes. Ainsi si l'on suppose que les canaux *s-d* et *r-d* utilisent respectivement un premier et un second intervalles de sous-porteuses d'un multiplex OFDM, des symboles pilotes dispersés dans le premier intervalle et le second intervalle permettront au terminal destinataire d'estimer les coefficients d'atténuation des deux canaux en question. Alternativement, le terminal destinataire pourra déterminer le taux d'erreur bit, BER (*Bit Error Rate*) ou le taux d'erreur paquet, FER (*Frame Error Rate*) sur le canal *s-d*, le canal *r-d* ou encore l'ensemble des deux canaux. Pour ce faire, on prévoira en sus du codage convolutif un codage de détection (CRC) ou de correction d'erreurs (ECC) au sein du terminal source et/ou du terminal relais.

Le taux d'erreur bit ou le taux d'erreur paquet peut être déterminé par le terminal destinataire pour chaque paquet reçu, au terme des itérations de turbodécodage. Il peut alternativement être moyenné sur la durée d'une période de transmission.

L'information sur l'état du canal peut encore comprendre le rapport signal sur bruit (SNR) sur l'un des canaux de transmission *s-d* ou *r-d*, voire sur l'ensemble des deux canaux. Le terminal destinataire estime ce rapport par exemple grâce à des symboles pilote : la distance entre le symbole effectivement reçu sur un canal et le symbole pilote de la constellation de modulation permet d'estimer le rapport signal sur bruit sur ce canal.

Dans tous les cas, l'information sur l'état du canal (coefficient d'atténuation, PER, PEB, SNR) est estimée par le terminal destinataire et est renvoyée vers le terminal relais. A partir de cette information, le contrôleur *CTLR* contrôle la sélection du second codeur convolutif parmi $N$. On comprendra que le terminal source n'a alors connaissance que de la seconde composante du turbocodage distribué et que la sélection est autonome dans le terminal relais. Alternativement, selon un mode de réalisation non représenté, l'information sur l'état du canal est renvoyée vers le terminal source et c'est ce dernier qui contrôle la sélection du second convolutif au sein du terminal relais. Plus précisément, le terminal source transmet alors un signal de sélection au terminal relais, par exemple sur un canal auxiliaire, et le terminal relais se contente alors de sélectionner le second codeur convolutif sur la base des instructions fournies par le signal de sélection.

Avant de préciser le critère de sélection du second codeur convolutif, il convient de rappeler que la courbe donnant le taux d'erreur bit (BER) en fonction du rapport signal à bruit (Eb/N$_0$ ou SNR) d'un turbocode présente deux régions de fonctionnement. Une première région, dite de cascade (encore dénommée *« waterfall »*), à faible niveau de SNR, dans laquelle la courbe présente une forte pente et une seconde région, dite de plancher (encore dénommée *« error-floor »*), à haut niveau de SNR, dans laquelle la courbe présente une faible pente. Dans un turbocode classique, les composantes, autrement dit les codes convolutifs qui le constituent (généralement des codes récursifs systématiques) sont identiques. Un tel turbocode est pour cette raison également qualifié de « symétrique ». Les turbocodes symétriques permettent généralement d'obtenir de bonnes performances en termes de taux d'erreur bit (ou de taux d'erreur paquet) soit dans la région de cascade soit dans la région de plancher mais non dans les deux régions à la fois. Pour cette raison, il a été proposé d'utiliser des turbocodes dits « asymétriques », dans lesquels les composantes diffèrent. On trouvera une description des turbocodes asymétriques et de leurs propriétés dans l'article de O.Y. Takeshita et al. intitulé « A note on asymetric turbo-codes » publié dans IEEE Comm. Letters, Vol. 3, n° 3, Mars 2009, pages 69-71 et dans l'article de P.C. Massey et al. intitulé « New developments in asymetric turbo codes » publié dans Proc. of International symposium on turbo codes and related topics », pages 93-100, Brest, France, 2000.

On suppose d'abord que le premier code constitutif, utilisé dans le terminal source, est un code faible, c'est-à-dire un code à faible distance minimale, ou de manière équivalente, s'il s'agit d'un code récursif systématique, un code à cycle court. Plus précisément, on désignera par code faible, un code convolutif dont la distance minimale est inférieure à celle du code récursif systématique de Berrou, c'est-à-dire un code défini par la fonction de transfert

$$g(D) = \frac{1+D^4}{1+D^2+D^3+D^4}$$ (on rappelle que le polynôme au dénominateur représente la partie récursive et celui au numérateur la partie directe ou FF), de débit 1/2, tel que spécifié dans l'article de P.C. Massey *et al.* précité. A l'inverse, un code présentant une distance minimale élevée, ou de manière équivalente, s'il s'agit d'un code récursif systématique, un code à cycle long sera appelé, code fort. Plus précisément, on se référera là encore à une comparaison avec le code récursif systématique utilisé par Berrou pour caractériser le code.

Le code faible *PCCC$^s$* utilisé dans le terminal source permet d'obtenir, lors du turbodécodage, des informations extrinsèques d'un bon degré de fiabilité si l'on se trouve dans la région de cascade et donc à faible rapport signal sur bruit.

Lorsque le canal se trouve dans un environnement de type urbain, ou lorsque le coefficient d'atténuation du canal est faible (forte atténuation sur le canal), lorsque le taux d'erreur bit ou paquet sur le canal est élevé ou encore lorsque le rapport signal sur bruit est faible, on sélectionne un second code convolutif également faible de manière à obtenir de bonnes performances dans la région de cascade. On entend ici par canal l'ensemble des canaux *s-d* et *r-d*, ou bien le canal *r-d* seulement.

*A contrario*, lorsque le canal se trouve dans un environnement rural, ou lorsque le coefficient du canal est proche de 1 (faible atténuation sur le canal), lorsque le taux d'erreur bit ou paquet est faible, ou encore lorsque le rapport signal sur bruit est élevé, on sélectionne un second code convolutif fort de manière à obtenir de bonnes performances dans la région de plancher.

Par exemple, dans le cas où N = 2, on pourra utiliser pour *PCCC$^s$* et $PCCC_1^r$ le codeur de Berrou ayant pour fonction de transfert :

$$g_0(D) = \frac{1+D^4}{1+D^2+D^3+D^4} \qquad (1)$$

et pour $PCCC_2^r$ le codeur récursif ayant pour fonction de transfert :

$$g_1(D) = \frac{1+D+D^2+D^4}{1+D^3+D^4} \qquad (2)$$

ou encore celui ayant pour fonction de transfert :

$$g_2(D) = \frac{1 + D + D^2 + D^4 + D^5 + D^6}{1 + D^3 + D^3 + D^5 + D^6} \qquad (3)$$

Si *N=3*, on pourra utiliser pour $PCCC_1^r$, $PCCC_2^r$ et $PCCC_3^r$ les codeurs de fonctions de transfert respectives $g_0(D)$, $g_1(D)$ et $g_2(D)$.

En pratique, pour appliquer le critère relatif au coefficient d'atténuation, au taux d'erreur bit, aux taux d'erreur paquet, au rapport signal sur bruit, le contrôleur compare l'information sur l'état du canal à une valeur de seuil. Dans l'exemple précité, avec *N* = 2, le contrôleur *CTLR* comparera par exemple la valeur de *SNR* sur le canal, estimée par le terminal destinataire avec un seuil prédéterminé $SNR_{Th}$ : si elle est supérieure à ce seuil le codeur $PCCC_1^r$ sera sélectionné et sinon le contrôleur sélectionnera le codeur $PCCC_2^r$.

Si l'on suppose maintenant que le premier codeur convolutif est fort, on sélectionnera un second convolutif faible lorsque l'on se situe dans la région de cascade et un second convolutif fort si l'on se situe dans la région de plancher.

Selon l'invention définie par une troisième variante, le canal de transmission est modélisé par un canal non ergodique, à évanouissements par bloc (*block fading channel*), hypothèse réaliste en téléphonie mobile dès lors que les terminaux sont en ligne de visée directe (LOS). Plus précisément on suppose ici que le canal de transmission *s-d* et le canal de transmission *r-d* sont à évanouissements par bloc. Les évanouissements peuvent être par bloc temporel et/ou fréquentiel selon que l'on considère une transmission par intervalle de temps et/ou intervalle de fréquence. A titre d'illustration, on supposera dans la suite que le terminal source et le terminal relais utilisent comme ressources de transmission des intervalles de sous-porteuses (*chunks*) d'un multiplex OFDM. Le canal de transmission OFDM peut être modélisé par un ensemble de *L* canaux élémentaires (*subchannels*), chaque canal élémentaire $\ell$ correspondant à un intervalle de sous-porteuses et étant caractérisé par un coefficient d'atténuation $\alpha_l$. Sans perte de généralité, on supposera que le coefficient est constant sur un paquet de données (plus précisément sur le paquet encodé par le premier codeur convolutif et le second paquet correspondant encodé par les seconds codeurs convolutifs). Dans ce cas, le coefficient $\alpha_\ell$ peut être considéré comme une variable aléatoire associé à un bloc, le bloc comprenant un ou plusieurs paquets. Les variables aléatoires $\alpha_\ell$ relatives à deux blocs distincts sont indépendantes et de même loi de distribution de probabilité, par exemple une loi de distribution de Rice. Le vecteur **a** = $(\alpha_1,...,\alpha_L)$ est un vecteur aléatoire à *L* composantes indépendantes.

Dans cette variante, le terminal destinataire mesure pour chaque bloc les coefficients d'atténuation $\alpha_1...,\alpha_L$ sur les *L* canaux élémentaires (à l'aide de symboles pilote) et met à jour les distributions de probabilité de chacun de ces coefficients, ou de manière équivalente de la loi de distribution du vecteur **a**, $p(\mathbf{a})$, ces lois de distribution étant transmises au terminal relais ou au terminal source, selon que l'un ou l'autre contrôle la sélection du second codeur convolutif. Dans ces deux cas, les distributions de probabilité des coefficients sont stockées localement (terminal source ou terminal relais selon le cas) dans une table mise à jour au cours du temps.

L'idée à la base de cette variante est d'utiliser comme critère de sélection une borne de probabilité, dite borne de l'union, majorant la probabilité d'erreur bit ou la probabilité d'erreur paquet en sortie du turbodécodeur. Plus précisément, cette borne est calculée pour chaque turbocode de composantes $\left(PCCC^s, PCCC_1^r\right)$, ..., $\left(PCCC^s, PCCC_N^r\right)$ et le second codeur convolutif correspondant à la plus petite borne est alors sélectionné.

Lorsque les codeurs $PCCC^s$, $PCCC_n^r$ sont des codeurs récursifs systématiques, on peut montrer que la probabilité conditionnelle d'erreur bit en sortie du turbodécodeur, connaissant le vecteur **a**, est majorée par la borne :

$$P_{eb}|\mathbf{a} = \sum_{w=w_{\min}}^{P} \frac{w}{P} \sum_{j=j_{\min}}^{2P} A_{w,j} \sum_{\mathbf{d},d} p(\mathbf{d},d) erfc\left(\frac{2R_c E_b}{N_0} \sum_{l=1}^{L} d_l \alpha_l^2\right) \qquad (4)$$

et, de manière similaire, la probabilité conditionnelle d'erreur paquet en sortie du turbodécodeur, connaissant le vecteur **a**, est majorée par la borne :

$$P_{ew}|\mathbf{a} = \sum_{w=w_{\min}}^{P} \sum_{j=j_{\min}}^{2P} A_{w,j} \sum_{\mathbf{d},d} p(\mathbf{d},d) erfc\left(\frac{2R_c E_b}{N_0} \sum_{l=1}^{L} d_l \alpha_l^2\right) \qquad (5)$$

la sommation sur d étant effectuée pour les vecteurs $\mathbf{d} = (d_1,...,d_L)$ tels que $\sum_{l=1}^{L} d_l = d$ où les composantes $d_l$ sont définies ci-après.

Dans les expressions (4) et (5), on a supposé que $N = 2$ (sélection d'un codeur récursif systématique parmi deux au sein du terminal relais) et l'on a noté : $P$ le nombre de bits d'information par paquet en entrée du turbocodeur distribué ou, de manière équivalente, le nombre de bits dans la partie systématique du paquet ; $w$ le poids de Hamming de cette partie systématique, $w_{min}$ la valeur minimale de ce poids ; $j = j_1 + j_2$ où $j_1$ et $j_2$ sont les poids de Hamming des bits de parité en sortie du premier codeur systématique et du second codeur récursif systématique, respectivement ; $j_{min}$ la valeur minimale de $j$ ; $erfc$ est la fonction d'erreur gaussienne complémentaire ; $d_\ell$ est le poids de Hamming des $k_\ell$ bits (bits systématiques et bits de parité) transmis sur le canal élémentaire $\ell$, $d = j + w$ est le poids de Hamming du turbocode distribué, $R_c$ est le débit du turbocode distribué, $\dfrac{E_b}{N_0}$ est le rapport signal sur bruit sur chaque canal élémentaire ; et :

$$A_{w,j} = \sum_{\substack{j_1,j_2 \\ j_1+j_2=j}} \frac{A^s_{w,j_1} A^r_{w,j_2}}{\binom{P}{w}} \tag{6}$$

où $A^s_{w,j_1}$ et $A^r_{w,j_2}$ sont respectivement le nombre de mots de code de poids $w + j_1$ en sortie du premier codeur récursif systématique (situé dans le terminal source) et le nombre de mots de code de poids $w + j_2$ en sortie du second codeur récursif systématique sélectionné dans le terminal relais et $\binom{P}{w}$ est le nombre de combinaisons de $w$ bits parmi $P$ ; $p(\mathbf{d},d)$ représente l'impact de l'effet de moyennage dû à l'entrelaceur et peut s'exprimer sous la forme :

$$p(\mathbf{d},d) = \frac{\binom{k_1}{d_1}\binom{k_2}{d_2}\cdots\binom{k_L}{d_L}}{\binom{3P}{d}} \tag{7}$$

Les expressions (4) et (5) donnent les bornes respectives de probabilité d'erreur bit et paquet connaissant le vecteur des coefficients d'atténuation sur les canaux élémentaires.

A partir de loi de probabilité $p(\mathbf{a})$, c'est-à-dire des distributions de probabilité des coefficients d'atténuation stockées dans la table précitée, on peut calculer une borne supérieure moyennée :

$$P^m_{eb} = \int_0^{+\infty} P_{eb}|\mathbf{a}.p(\mathbf{a})d\mathbf{a} \tag{8}$$

et

$$P^m_{ew} = \int_0^{+\infty} P_{ew}|\mathbf{a}.p(\mathbf{a})d\mathbf{a} \tag{9}$$

la sommation étant effectuée ici sur les valeurs positives des $\alpha_\ell$.

Ces bornes supérieures moyennes sont relativement lâches et on calculera avantageusement des bornes supérieures moyennes plus strictes à l'aide de :

$$P_{eb}^m = \int_0^{+\infty} \min(\frac{1}{2}, P_{eb}|\mathbf{a}).p(\mathbf{a})d\mathbf{a} \qquad (10)$$

$$P_{ew}^m = \int_0^{+\infty} \min(\frac{1}{2}, P_{ew}|\mathbf{a}).p(\mathbf{a})d\mathbf{a} \qquad (11)$$

Le terminal en charge du contrôle de la sélection du second codeur convolutif calcule la borne supérieure moyenne $P_{eb}^m$, selon l'expression (8) ou (10), ou bien la borne supérieure $P_{ew}^m$, selon l'expression (9) ou (11), ce pour les deux codeurs $PCCC_1^r$, $PCCC_2^r$, et de manière plus générale pour les N codeurs $PCCC_1^r$, ..., $PCCC_N^r$, et en déduit celui qui réalise la borne supérieure moyenne la plus faible. Ce codeur convolutif est alors sélectionné pour la transmission du paquet suivant ou bien pour la transmission des paquets pendant une période donnée, correspondant à la fréquence de mise à jour de $p(\mathbf{a})$.

Selon une quatrième variante, le contrôleur de sélection utilise directement la mesure des coefficients d'atténuation $\alpha_1,...,\alpha_L$ pour estimer la borne supérieure de probabilité d'erreur bit ou d'erreur paquet et sélectionner le second codeur convolutif réalisant la borne supérieure la plus faible. Si l'on note $\hat{\mathbf{a}} = (\hat{\alpha}_1,...,\hat{\alpha}_L)$ le vecteur des coefficients d'atténuation obtenus à la dernière mesure, on détermine alors simplement la borne $P_{eb}^m$ ou la borne $P_{ew}^m$ comme suit :

$$P_{eb}^m = P_{eb}|\hat{\mathbf{a}} \qquad (12)$$

$$P_{ew}^m = P_{ew}|\hat{\mathbf{a}} \qquad (13)$$

où $P_{eb}|\mathbf{a}$ et $P_{ew}|\mathbf{a}$ sont les expressions données par les expressions (4) et (5) respectivement.

La mise en oeuvre de cette variante suppose que les coefficients d'atténuation mesurés à la période de transmission précédente constituent une bonne estimation des coefficients d'atténuation des canaux élémentaires à la période de transmission suivante, c'est-à-dire que les canaux élémentaires varient peu entre deux instants de mesure.

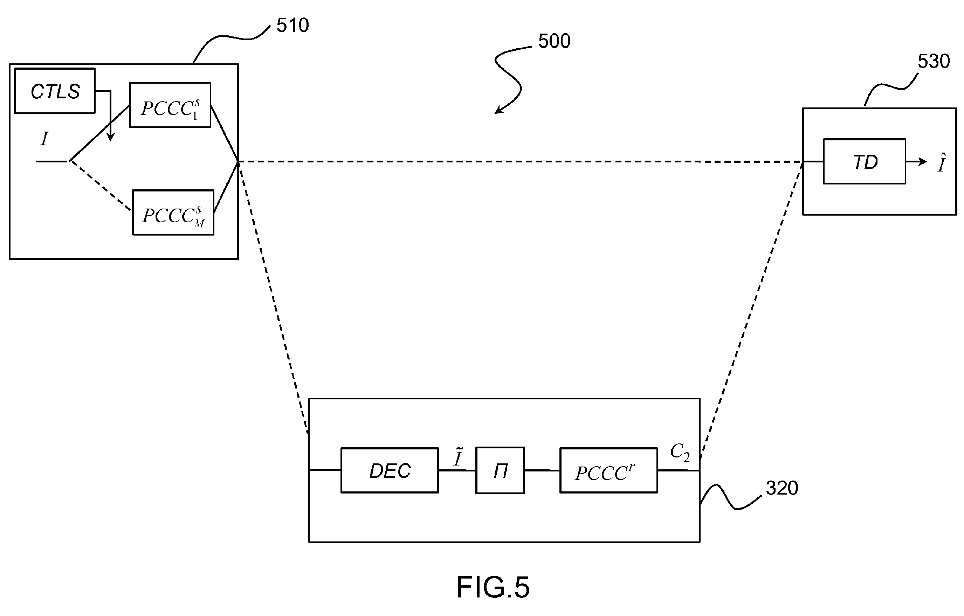

La Fig. 5 illustre de manière schématique un réseau coopératif selon un second mode de réalisation de l'invention.

Dans ce mode de réalisation, le second codeur convolutif, désigné par $PCCC^r$ est fixe alors que le premier codeur convolutif est adaptatif. Plus précisément, le premier codeur convolutif, situé dans le terminal source, 510, est sélectionné parmi une pluralité M de premiers codeurs convolutifs prédéterminés, notés $PCCC_1^s$, ..., $PCCC_M^s$, la sélection étant effectuée, comme précédemment, à partir d'une caractéristique du canal de transmission s-r et/ou du canal de transmission r-d. A la différence du premier mode de réalisation, le contrôle de la sélection est toujours effectué au niveau du terminal source, au moyen d'un contrôleur désigné par *CTLS.*

L'homme du métier comprendra que les différentes variantes exposées dans le cadre du premier mode de réalisation peuvent se décliner de manière similaire dans le second mode de réalisation, de sorte que leur description ne sera pas reprise ici. On indiquera simplement que, dans le cadre de la seconde variante, on sélectionne un code convolutif faible si le canal se trouve dans un environnement de type urbain, lorsque le coefficient d'atténuation du canal est faible (forte atténuation sur le canal), ou lorsque le taux d'erreur bit ou paquet sur le canal est élevé ou encore lorsque le rapport signal sur bruit est faible. *A contrario,* on sélectionne un code convolutif fort si le canal se trouve dans un environnement de type rural, lorsque le coefficient d'atténuation du canal est fort (faible atténuation sur le canal), ou lorsque le taux d'erreur bit ou paquet sur le canal est faible ou encore lorsque le rapport signal sur bruit est élevé.

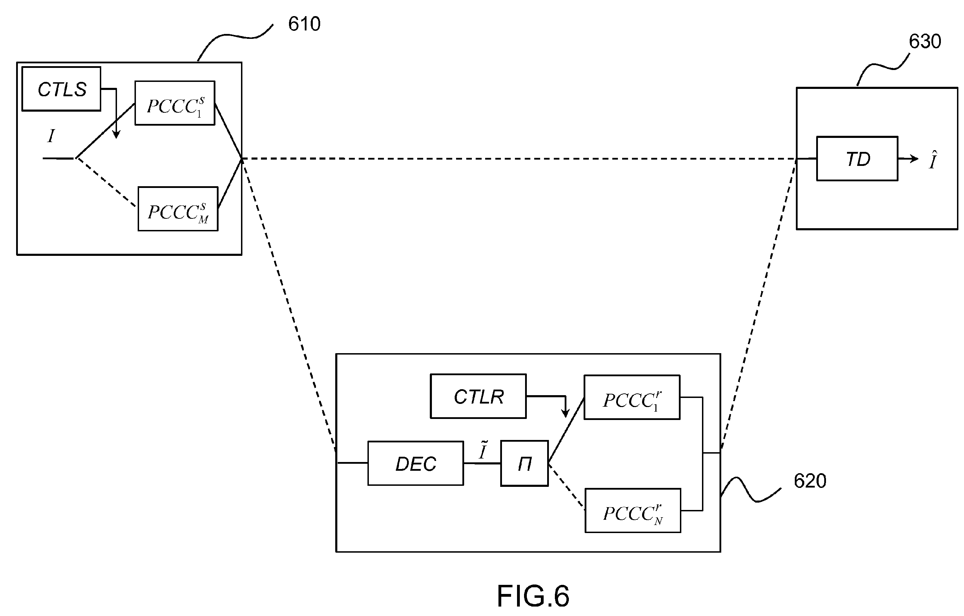

La Fig. 6 représente de manière schématique un réseau coopératif selon un troisième mode de réalisation de l'invention.

Dans ce mode de réalisation, le premier et le second codeurs convolutifs sont adaptatifs. Plus précisément, le premier codeur convolutif est sélectionné parmi une pluralité M de premiers codeurs convolutifs prédéterminés, notés $PCCC_1^s$ ..., $PCCC_M^s$, et le second codeur convolutif est sélectionné parmi une pluralité N de seconds codeurs convolutifs prédéterminés, notés $PCCC_1^r$, ..., $PCCC_N^1$. Le contrôle de la sélection parmi les premiers codeurs convolutifs est effectué par un premier contrôleur, *CTLS,* situé dans le terminal source, 610, et le contrôle de la sélection parmi les seconds codeurs convolutifs est effectué par un second contrôleur, *CTLR,* situé dans le terminal relais, 620. Alternativement, le contrôle de la sélection des premiers et des seconds codeurs convolutifs est centralisé au niveau du terminal source, autrement dit il est effectué par le seul contrôleur *CTLS.*

L'homme du métier comprendra que le troisième mode de réalisation est une combinaison des premier et second modes de réalisation, de sorte que ce troisième mode se décline selon les quatre variantes précédemment exposées sans qu'il soit nécessaire de les décrire à nouveau.

Le troisième mode de réalisation comporte toutefois une cinquième variante spécifique. Dans cette cinquième variante, le contrôle de la sélection est centralisé au niveau du terminal source, 610. Le terminal destinataire, 630, estime séparément l'état du canal *s-d* et l'état du canal *r-d* et transmet ces deux états au contrôleur *CTLS*

La sélection est alors effectuée comme suit :

Si le coefficient d'atténuation du canal *s-d* est plus faible que celui du canal *r-d*, ou si le taux d'erreur bit/paquet sur le canal *s-d* est plus élevé que sur le canal *r-d* ou encore si le rapport signal sur bruit sur le canal *s-d* est plus faible que sur le canal *r-d,* on optera pour un premier codeur convolutif plus faible que le second codeur convolutif. Dans le cas contraire, on optera pour un premier codeur convolutif plus fort que le premier codeur convolutif. De cette manière, le turbodécodeur bénéficie dans tous les cas de la meilleure fiabilité des informations extrinsèques fournies par le décodeur associé au codeur le plus faible dans la région de cascade et de la meilleure convergence due au décodeur associé au codeur le plus fort dans la région de plancher.

Dans la description des modes de réalisation de l'invention, il a simplement été fait référence à un terminal source, un terminal relais et un terminal destinataire sans préciser la nature de ces terminaux. L'homme du métier comprendra que le terminal source peut être une station de base, auquel cas le terminal destinataire est un terminal utilisateur, et qu'à l'inverse le terminal source peut être un terminal utilisateur, auquel cas le terminal destinataire est une station de base. Ainsi la présente invention s'applique aussi bien aux communications sur une voie montante que sur une voie descendante.

## Revendications

1. Méthode de transmission de paquets de données pour réseau coopératif comprenant un terminal source, un terminal destinataire et au moins un terminal relais, les canaux de transmission entre le terminal source et le terminal destinataire, d'une part, et entre le terminal relais et le terminal destinataire, d'autre part, étant non ergodiques et à évanouissements par bloc, le terminal source codant un paquet de données à l'aide d'un premier codeur convolutif pour générer un premier paquet codé et le transmettre au terminal destinataire ainsi qu'au terminal relais, le terminal relais recevant et décodant le premier paquet codé, entrelaçant les données du paquet ainsi décodé et codant le paquet de données entrelacées à l'aide d'un second codeur convolutif pour générer un second paquet codé et le transmettre au dit terminal destinataire, le premier et le second codeurs convolutifs formant un turbocodeur distribué entre le terminal source et le terminal relais, **caractérisée en ce que** :

   (a) on sélectionne ledit premier codeur convolutif parmi une pluralité de premiers codeurs convolutifs prédéterminés, et/ou
   (b) on sélectionne ledit second codeur convolutif parmi une pluralité de seconds codeurs convolutifs prédéterminés ;

   la sélection en (a) et/ou (b) étant effectuée à partir de statistiques des coefficients d'évanouissement par bloc du canal entre le terminal source et le terminal destinataire et/ou du canal entre le terminal relais et le terminal destinataire.

2. Méthode de transmission de paquets selon la revendication 1, **caractérisée en ce que**, pour chaque premier codeur convolutif et/ou second codeur convolutif prédéterminé, on calcule les probabilités conditionnelles d'erreur bit ou d'erreur paquet relatives aux différentes valeurs possibles desdits coefficients d'évanouissement et on en déduit des bornes de probabilité d'erreur bit ou d'erreur paquet que l'on obtiendrait en utilisant ledit premier codeur convolutif et/ou ledit second codeur convolutif prédéterminé.

3. Méthode de transmission de paquets selon la revendication 2, **caractérisée en ce que** l'on sélectionne le premier codeur convolutif et/ou le second convolutif prédéterminé permettant d'obtenir la plus faible borne de taux d'erreur bit ou de taux d'erreur paquet.

4. Méthode de transmission de paquets selon l'une des revendications précédentes, **caractérisée en ce que** le terminal source contrôle à la fois la sélection du premier et/ou du second codeur convolutif.

5. Méthode de transmission de paquets selon l'une des revendications 1 à 3, **caractérisée en ce que** le terminal source contrôle la sélection du premier codeur convolutif et/ou le terminal relais contrôle la sélection du second codeur convolutif.

## Patentansprüche

1. Verfahren zur Übertragung von Datenpaketen für ein kooperatives Netzwerk, umfassend ein Quellenterminal, ein Zielterminal und wenigstens ein Relaisterminal, wobei die Übertragungskanäle zwischen dem Quellenterminal und dem Zielterminal einerseits und zwischen dem Relaisterminal und dem Zielterminal andererseits nicht ergodisch sind und einen blockweisen Schwund aufweisen, wobei das Quellenterminal ein Datenpaket mit Hilfe eines ersten Faltungscodierers codiert, um ein erstes codiertes Paket zu erzeugen und es an das Zielterminal sowie an das Relaisterminal zu übertragen, wobei das Relaisterminal das erste codierte Paket empfängt und decodiert, die Daten des derart decodierten Pakets verschachtelt und das Paket von verschachtelten Daten mit Hilfe eines zweiten Faltungscodierers codiert, um ein zweites codiertes Paket zu erzeugen und es an das Zielterminal zu übertragen, wobei der erste und der zweite Faltungscodierer einen verteilten Turbocodierer zwischen dem Quellenterminal und dem Relaisterminal bilden, **dadurch gekennzeichnet, dass**:

   (a) man den ersten Faltungscodierer aus einer Mehrzahl von vorbestimmten ersten Faltungscodierern auswählt, und/oder

   (b) man den zweiten Faltungscodierer aus einer Mehrzahl von vorbestimmten zweiten Faltungscodierern auswählt;

   wobei die Auswahl bei (a) und/oder (b) durchgeführt wird ausgehend von Statistiken der Koeffizienten des blockweisen Schwunds des Kanals zwischen dem Quellenterminal und dem Zielterminal und/oder des Kanals zwischen dem Relaisterminal und dem Zielterminal.

2. Verfahren zur Übertragung von Paketen nach Anspruch 1, **dadurch gekennzeichnet, dass** man für jeden vorbestimmten ersten Faltungscodierer und/oder zweiten Faltungscodierer die bedingten Wahrscheinlichkeiten eines Bitfehlers oder eines Paketfehlers bezüglich der verschiedenen möglichen Werte der Schwundkoeffizienten berechnet, und man hieraus Wahrscheinlichkeitsgrenzen des Bitfehlers oder des Paketfehlers ableitet, die man bei Verwendung des vorbestimmten ersten Faltungscodierers und/oder zweiten Faltungscodierers erhalten würde.

3. Verfahren zur Übertragung von Paketen nach Anspruch 2, **dadurch gekennzeichnet, dass** man den vorbestimmten ersten Faltungscodierer und/oder zweiten Faltungscodierer auswählt, der es erlaubt, die kleinste Grenze der Bitfehlerrate oder der Paketfehlerrate zu erhalten.

4. Verfahren zur Übertragung von Paketen nach einem der vorhergehenden Ansprüche, **dadurch gekennzeichnet, dass** das Quellenterminal gleichzeitig die Auswahl des ersten und/oder des zweiten Faltungscodierers steuert.

5. Verfahren zur Übertragung von Paketen nach einem der Ansprüche 1 bis 3, **dadurch gekennzeichnet, dass** das Quellenterminal die Auswahl des ersten Faltungscodierers steuert, und/oder das Relaisterminal die Auswahl des zweiten Faltungscodierers steuert.

## Claims

1. A method for transmitting data packets for a cooperative network comprising a source terminal, a recipient terminal and at least one relay terminal, the transmission channels between the source terminal and the destination terminal, on the one hand, and between the relay terminal and the destination terminal, on the other hand, being non-ergodic and block fading channels, the source terminal coding a data packet using a first convolutional coder for generating a first coded packet and transmitting it to the recipient terminal as well as to the relay terminal, the relay terminal receiving and decoding the first coded packet, interleaving the data of thus decoded packet and coding the interleaved data packet using a second convolutional coder for generating a second coded packet and transmitting it to said recipient terminal, the first and second convolutional coders forming a turbocoder distributed between the source terminal and the relay terminal, **characterised in that**:

   (a) the first convolutional coder is selected from a plurality of first predetermined convolutional coders, and/or
   (b) said second convolutional coder is selected from a plurality of second predetermined convolutional coders;

the selection in (a) and/or (b) being performed from statistic of fading coefficients per block of the channel between the source terminal and the recipient terminal and/or the channel between the relay terminal and the recipient terminal.

2. The method for transmitting packets according to claim 1, **characterised in that**, for each first predetermined convolutional coder and/or second convolutional coder, the bit error or packet error conditional probabilities relating to different possible values of said fading coefficients are calculated and bit error or packet error probability bounds that would be obtained using said first predetermined convolutional coder and/or second convolutional coder are deduced therefrom.

3. The method for transmitting packets according to claim 2, **characterised in that** the first predetermined convolutional coder and/or second convolutional coder enabling the lowest bit error rate or packet error rate bound to be obtained are selected.

4. The method for transmitting packets according to any of the preceding claims, **characterised in that** the source terminal controls both the selection of the first and/or second convolutional coder.

5. The method for transmitting packets according to claim 1 to 3, **characterised in that** the source terminal controls the selection of the first convolutional coder and/or the relay terminal controls the selection of the second convolutional coder.

FIG.1

FIG.2

**FIG.3**

FIG.4

FIG.5

FIG.6

EP 2 504 943 B1

EP 2 504 943 B1

**Littérature non-brevet citée dans la description**

- Cooperative wireless networking beyond store-and forward: perspectives for PHY and MAC design. **S. VALENTIN et al.** Wireless Personal Communications. 2009
- **B. ZHAO et al.** Distributed turbo coded diversity for relay channel. *Electronics Letters,* 15 Mai 2003, vol. 29 (10
- **RAGNAR THOBABEN.** On distributed codes with noisy relays. *IEEE conference on signals, systems and computers,* 26 Octobre 2008, 1010-1014
- **C. BERROU et al.** Near Shannon limit error-correcting coding and decoding : Turbo Codes. *Proceedings of ICC'93,* 1064-1070
- **O.Y. TAKESHITA et al.** A note on asymetric turbo-codes. *IEEE Comm. Letters,* Mars 2009, vol. 3 (3), 69-71
- **P.C. MASSEY et al.** New developments in asymetric turbo codes. *Proc. of International symposium on turbo codes and related topics,* 2000, 93-100